# EUROPEAN PATENT APPLICATION

(11) **EP 4 800 843 A1**
(43) Date of publication of application: **02.09.2026**
(21) Application number: 24890329.6
(22) Date of filing: 20.09.2024
(51) Int. Cl.: H01Q 21/00, H04W 52/02

(54) **POWER ADJUSTMENT NETWORK, FEED NETWORK, BASE STATION ANTENNA, AND BASE STATION SYSTEM**

(30) Priority: 15.11.2023 CN 202311532973
(71) Applicant: Huawei Technologies Co., Ltd., Shenzhen, Guangdong 518129 (CN)
(72) Inventor: PENG, Zhongwei, Shenzhen, Guangdong 518129 (CN); LI, Jianping, Shenzhen, Guangdong 518129 (CN); WANG, Jinju, Shenzhen, Guangdong 518129 (CN); WANG, Xinqiang, Shenzhen, Guangdong 518129 (CN); SONG, Sinian, Shenzhen, Guangdong 518129 (CN)
(74) Representative: Maiwald GmbH
(86) International application number: PCT/CN2024/119973
(87) International publication number: WO 2025/102971

(57) **Abstract**

A power adjustment network is provided, including: a first input end, a second input end, a first output end, a second output end, a first phase-shifting unit, and a first switching unit, where a first branch is formed by connecting the first input end and the first output end; a second branch is formed by connecting the first input end, the first phase-shifting unit, the first switching unit, and the second output end; and a third branch is formed by connecting the second input end, the first switching unit, and the second output end. When the first switching unit controls the second branch to be connected, the first power amplifier is operative. When the first switching unit controls the third branch to be connected, both the first power amplifier and the second power amplifier work. Therefore, when there are a small quantity of users, the first switching unit may control the second branch to be connected, so that the first power amplifier is operative, and a base station works at a low working power, thereby reducing energy consumption of the base station. In addition, a formed beam range remains unchanged, thereby ensuring communication quality of the users.

## Description

This application claims priority to Chinese Patent Application No. 202311532973.5, filed on November 15, 2023 and entitled "POWER ADJUSTMENT NETWORK, FEED NETWORK, BASE STATION ANTENNA, AND BASE STATION SYSTEM", which is incorporated herein by reference in its entirety.

### TECHNICAL FIELD

This application relates to the field of wireless communication technologies, and in particular, to a power adjustment network, a feed network, a base station antenna, and a base station system.

### BACKGROUND

In a wireless communication system, energy consumption of a radio frequency part is a primary source of energy consumption of a base station, and is related to energy consumption of the base station and a maximum capacity and a maximum transmit power of the base station. To ensure communication quality of users, the base station needs to operate at the maximum transmit power at all times. Clearly, operating at the maximum transmit power when there are a small quantity of users results in a significant waste of electric energy. Therefore, a technical solution for reducing energy consumption of the base station is required.

### SUMMARY

To resolve the foregoing problem, embodiments of this application provide a power adjustment network, a feed network, a base station antenna, and a base station system. A base station may be adjusted to be at a working power based on a quantity of users. When there are a small quantity of users, the base station may be at a low working power, thereby reducing energy consumption of the base station.

Therefore, the following technical solutions are used in embodiments of this application.

According to a first aspect, an embodiment of this application provides a power adjustment network, including a first input end, a second input end, a first output end, and a second output end. The first input end is configured to electrically connect to the first power amplifier; the second input end is configured to electrically connect to the second power amplifier; the first output end is configured to electrically connect to the first antenna array; and the second output end is configured to electrically connect to the second antenna array. The power adjustment network further includes a first phase-shifting unit and a first switching unit. An input end of the first phase-shifting unit is electrically connected to the first input end, and is configured to control a phase of a radio frequency signal that is output when the first input end and the second output end are connected. One input end of the first switching unit is connected to an output end of the first phase-shifting unit, another input end is electrically connected to the second input end, and an output end is electrically connected to the second output end. Therefore, the power adjustment network forms three branches, where a first branch is formed by connecting the first input end and the first output end; a second branch is formed by connecting the first input end, the first phase-shifting unit, the first switching unit, and the second output end; and a third branch is formed by connecting the second input end, the first switching unit, and the second output end. When the first switching unit controls the second branch to be connected, the first power amplifier provides a radio frequency signal of a first power for the first antenna array and the second antenna array. When the first switching unit controls the third branch to be connected, the first power amplifier provides a radio frequency signal of a first power for the first antenna array, and the second power amplifier provides a radio frequency signal of a second power for the second antenna array.

That is, this embodiment of this application provides a power adjustment network, where an input side is connected to a first power amplifier and a second power amplifier, and an output side is connected to a first antenna array and a second antenna array. The first power amplifier and the first antenna array are connected through a first branch, the first power amplifier and the second antenna array are connected through a second branch, and the second power amplifier and the second antenna array are connected through a third branch. When there are a small quantity of users, a first switching unit may control the second branch to be connected, so that the first power amplifier provides a radio frequency signal of a first power for the first antenna array and the second antenna array. Therefore, the first power amplifier in a base station works, and the base station may work at a low working power, thereby reducing energy consumption of the base station. When there are a large quantity of users, a first switching unit controls the third branch to be connected. In this case, the first power amplifier provides a radio frequency signal of a first power for the first antenna array, and the second power amplifier provides a radio frequency signal of a second power for the second antenna array. Therefore, both the first power amplifier and the second power amplifier in a base station work, and the base station may work at a high working power, thereby ensuring communication quality of users. In this embodiment of this application, a first phase-shifting unit is disposed on the second branch, and is configured to control a phase of a radio frequency signal that is output when the second branch is connected, so as to ensure that a phase of a signal output from the second output end does not change before and after the first switching unit switches between connecting the second branch and connecting the third branch. In this way, when a working power of the base station is reduced, a phase of the second antenna array does not change before and after the power is reduced, so that a formed beam range does not change, thereby ensuring communication quality of users. That is, before and after the working power of the base station is reduced, the formed beam range does not change while the power is reduced, thereby ensuring communication quality of users while achieving energy saving. Further, the entire process of reducing the working power of the base station involves switching a state of the first switching unit without any other work, making it simple to operate, and the power adjustment network features a simple structure, low costs, easy implementation, and a significant energy-saving effect. In this embodiment of this application, the power adjustment network is added between the power amplifier and a feed network of a base station antenna, so that power of the base station is reduced at low costs when there are a small quantity of users. For example, the first power is equal to the second power, the first switching unit may control the base station to be in a half-power state when the second branch is connected, and the first switching unit may control the base station to be in a full-power state when the third branch is connected.

In a possible implementation, a fourth branch is formed by connecting the second input end, the first switching unit, the first phase-shifting unit, and the first output end, and the first switching unit is further configured to control the fourth branch to be connected, so that the first power amplifier and the second power amplifier provide a radio frequency signal of a third power for the first antenna array, where the third power is a sum of the first power and the second power.

In this implementation, this embodiment of this application provides another working state of the power adjustment network. In the working state, the first switching unit connects the fourth branch, that is, connects the second input end and the first output end, so that the first power amplifier and the second power amplifier simultaneously provide the radio frequency signal for the first antenna array. The power of the radio frequency signal is the sum of the first power and the second power, which increases an operating frequency of the first antenna array and increases an operating frequency range of the first antenna array.

In another possible implementation, a second switching unit is disposed on the second branch, and the second switching unit is configured to connect or disconnect the second branch.

In this implementation, the second switching unit is disposed on the second branch, and connection and disconnection of the second branch may be implemented by using the second switching unit. Therefore, when the first branch and the third branch are connected, the second switching unit may disconnect the second branch, so as to ensure a working state of the second branch.

In another possible implementation, the power adjustment network further includes a matching circuit. The matching circuit is connected to the first input end, and is configured to perform circuit matching for the first branch when the first switching unit controls the third branch to be connected.

In this implementation, the power adjustment network further includes the matching circuit, to implement circuit matching of the first switching unit in different states, so as to ensure that output signals of the power adjustment network are consistent before and after the first switching unit switches the second branch and the third branch.

In another possible implementation, a third switching unit is further disposed between the matching circuit and the first input end, and the third switching unit is configured to connect or disconnect the matching circuit and the first input end.

In this implementation, the power adjustment network further includes the third switching unit. The third switching unit is connected between the first input end and the matching circuit, and is configured to implement connection and disconnection of the matching circuit.

In another possible implementation, the matching circuit includes a microstrip circuit or a lumped-element circuit, and the lumped-element circuit includes an inductor or a capacitor.

In this implementation, this embodiment of this application provides an implementation of the matching circuit. The matching circuit may be but is not limited to the microstrip circuit, the lumped-element circuit, or the like.

In another possible implementation, the first phase-shifting unit includes a phase shifter, and/or the first switching unit includes a single-pole double-throw switch.

In this implementation, this embodiment of this application provides an implementation of the first phase-shifting unit and the first switching unit. The first phase-shifting unit may be but is not limited to the phase shifter, and the first switching unit may be but is not limited to the single-pole double-throw switch.

In another possible implementation, the phase shifter is an analog phase shifter; or the single-pole double-throw switch is a metal-oxide-semiconductor field-effect transistor, a diode, a micro-electro-mechanical system, or a reed switch.

In this implementation, this embodiment of this application provides an implementation of the phase shifter and the single-pole double-throw switch. The phase shifter may be but is not limited to the analog phase shifter. The single-pole double-throw switch may be but is not limited to the metal-oxide-semiconductor field-effect transistor, the diode, the micro-electro-mechanical system, or the reed switch.

In another possible implementation, the power adjustment network further includes a third input end, a third output end, a second phase-shifting unit, and a fourth switching unit. An input end of the second phase-shifting unit is connected to the first switching unit, an output end of the second phase-shifting unit is connected to one input end of the fourth switching unit, and the second phase-shifting unit is configured to control a phase of a radio frequency signal that is output when the second input end and the third output end are connected; and another input end of the fourth switching unit is connected to the third input end, and an output end of the fourth switching unit is connected to the third output end.

In this implementation, the power adjustment network is not limited to having two input ends. That is, the power adjustment network may be configured with more input ends, and each input end is connected to a power amplifier, so that the working power of the base station can be selected from a plurality of powers, thereby enabling the base station to have a plurality of low-power states.

In another possible implementation, the power adjustment network further includes a control module, configured to control the first switching unit to switch between connecting the second branch and connecting the third branch.

In this implementation, the power adjustment network further includes the control module. The control module may control the first switching unit to switch between the second branch and the third branch.

In another possible implementation, the power adjustment network further includes a detection module, configured to: detect a quantity of users within a beam range of the antenna array; and send a first signal to the control module when the quantity of users exceeds a user threshold, where the first signal indicates the first switching unit to connect the third branch, and send a second signal to the control module when the quantity of users does not exceed the user threshold, where the second signal indicates the first switching unit to connect the second branch.

In this implementation, the power adjustment network further includes the detection module, configured to detect the quantity of users within the beam range of the antenna array. Therefore, the power adjustment network may control, based on the quantity of users, the first switching unit to switch between the second branch and the third branch.

According to a second aspect, an embodiment of this application provides a feed network, including a first power divider, a second power divider, and the power adjustment network in any one of the foregoing implementations. An input end of the first power divider is connected to the first output end, and an output end of the first power divider is connected to the first antenna array; and an input end of the second power divider is connected to the second output end, and an output end of the second power divider is connected to the second antenna array.

That is, this embodiment of this application provides a new feed network, including the power adjustment network in embodiments of this application, so that the new feed network has a feeding function and a function of adjusting an input power of the array antenna.

In a possible implementation, the feed network further includes a third phase-shifting unit and a fourth phase-shifting unit. The output end of the first power divider is connected to the third phase-shifting unit, the third phase-shifting unit is connected to the first antenna array, and the third phase-shifting unit is configured to adjust a phase difference between different radiating elements of the first antenna array; and the output end of the second power divider is connected to the fourth phase-shifting unit, the fourth phase-shifting unit is connected to the second antenna array, and the fourth phase-shifting unit is configured to adjust a phase difference between different radiating elements of the second antenna array.

In this implementation, the feed network further includes the third phase-shifting unit and the fourth phase-shifting unit. The third phase-shifting unit and the fourth phase-shifting unit are respectively configured to control phases of radiating elements inside the first array antenna and the second array antenna, so as to form beams with different directions.

In another possible implementation, the feed network further includes a transmission component or a calibration network. The transmission component is configured to perform phase adjustment by controlling a pull-rod position of the first phase-shifting unit, the third phase-shifting unit, or the fourth phase-shifting unit; and the calibration network is configured to perform phase adjustment on the first phase-shifting unit, the third phase-shifting unit, or the fourth phase-shifting unit by comparing calibration signals.

In this implementation, the feed network further includes the transmission component or the calibration network, configured to implement phase calibration of the phase-shifting unit.

According to a third aspect, an embodiment of this application provides another feed network, configured to control an input power of an antenna array in n rows and m columns, where both n and m are integers greater than or equal to 1, and the feed network includes at least two power adjustment networks described above, where a first power adjustment network is configured to adjust an input power between different rows in the n rows of the antenna array, or a second power adjustment network is configured to adjust an input power between different columns in the m columns of the antenna array.

That is, in an antenna array distributed in a form of a matrix, one power adjustment network may adjust an input power of an antenna array in a row or a column. Therefore, this embodiment of this application provides the another feed network, including at least two power adjustment networks described above, to control the input power of the antenna array in n rows and m columns.

In a possible implementation, the first power adjustment network is connected in series to the second power adjustment network, so that the two power adjustment networks simultaneously adjust the input power of the antenna array.

In this implementation, the first power adjustment network is connected in series to the second power adjustment network, so that the two power adjustment networks can simultaneously adjust the input power of the antenna array. For example, the first power is equal to the second power. The first power adjustment network may implement a half-power state or a full-power state of the base station by using the first switching unit. The first power adjustment network is connected in series to the second power adjustment network, and may implement a quarter-power state, a half-power state, or a full-power state of the base station by using their respective first switching units.

According to a fourth aspect, an embodiment of this application provides a base station antenna, including an antenna array and the foregoing feed network. The antenna array includes a first antenna array and a second antenna array, and the feed network is configured to: perform feeding processing on signals received or sent by the first antenna array and the second antenna array, and adjust input powers of the first antenna array and the second antenna array.

According to a fifth aspect, an embodiment of this application provides a base station system, including a radio frequency unit and the foregoing base station antenna. The radio frequency unit includes at least a first power amplifier and a second power amplifier, the first power amplifier is electrically connected to the first input end and is configured to provide a radio frequency signal of a first power, and the second power amplifier is electrically connected to the second input end and is configured to provide a radio frequency signal of a second power, where when the first switching unit controls the second branch to be connected, the second power amplifier is turned off, and when the first switching unit controls the third branch to be connected, the second power amplifier works.

### BRIEF DESCRIPTION OF DRAWINGS

The following briefly describes the accompanying drawings used in embodiments or technical descriptions.
FIG. 1 is a diagram of composition of a base station system according to an embodiment of this application;
FIG. 2 is a diagram of composition of a base station antenna according to an embodiment of this application;
FIG. 3 is a diagram of composition of a power adjustment network according to an embodiment of this application;
FIG. 4 is a diagram of a first working state of a power adjustment network according to an embodiment of this application;
FIG. 5 is a diagram of a second working state of a power adjustment network according to an embodiment of this application;
FIG. 6 is a diagram of composition of another power adjustment network according to an embodiment of this application;
FIG. 7 is a diagram of composition of still another power adjustment network according to an embodiment of this application;
FIG. 8 is a diagram of composition of an embodiment of a power adjustment network according to an embodiment of this application;
FIG. 9 is a diagram of a first working state of an embodiment of a power adjustment network according to an embodiment of this application;
FIG. 10 is a diagram of a second working state of an embodiment of a power adjustment network according to an embodiment of this application;
FIG. 11 is a diagram of composition of an antenna array according to an embodiment of this application;
FIG. 12 is a diagram of an application scenario of a first working state of an embodiment of a power adjustment network according to an embodiment of this application;
FIG. 13 is a diagram of an application scenario of a second working state of an embodiment of a power adjustment network according to an embodiment of this application;
FIG. 14 is a diagram of an application scenario of a third working state of an embodiment of a power adjustment network according to an embodiment of this application; and
FIG. 15 is a diagram of an application scenario of a plurality of power adjustment networks according to an embodiment of this application.

### DESCRIPTION OF EMBODIMENTS

The following describes the technical solutions in embodiments of this application with reference to the accompanying drawings in embodiments of this application.

The term "and/or" in this specification describes an association relationship between associated objects and represents that three relationships may exist. For example, A and/or B may represent the following three cases: Only A exists, both A and B exist, and only B exists. The character "/" in this specification indicates an "or" relationship between the associated objects. For example, A/B indicates A or B.

In the specification and claims of this application, the terms "first", "second", and the like are intended to distinguish between different objects, but do not indicate a particular order of the objects. For example, a first response message, a second response message, and the like are used to distinguish between different response messages, but do not indicate a particular order of the response messages.

In embodiments of this application, the term such as "example" or "for example" is used to give an example, an illustration, or a description. Any embodiment or design scheme described as an "example" or "for example" in embodiments of this application should not be explained as being more preferred or having more advantages than another embodiment or design scheme. Specifically, use of the term such as "example" or "for example" is intended to present a relative concept in a specific manner.

In the descriptions of embodiments of this application, unless otherwise specified, "a plurality of" means two or more. For example, a plurality of processing units mean two or more processing units, and a plurality of elements mean two or more elements.

For ease of understanding of the solutions provided in embodiments of this application, some terms used in the solutions are first briefly described.

Doherty (Doherty) amplifier: The Doherty amplifier is a power amplifier design for a wireless communication system. The Doherty amplifier improves work efficiency by combining two amplifiers of different power levels, that is, a main amplifier and an auxiliary amplifier. In this combination manner, the Doherty amplifier can keep a low distortion level while maintaining high power efficiency.

In the wireless communication system, a radio frequency part is a part with highest energy consumption of a base station, and energy consumption of the base station is closely related to a maximum capacity and a maximum transmit power of the base station. To ensure communication quality of users, the base station needs to keep the maximum transmit power at all times. Clearly, working at the maximum transmit power when there are a small quantity of users wastes a large amount of electric energy.

One feasible technical solution is to reduce energy consumption by improving efficiency of a radio frequency power amplifier. For example, a "golden efficiency improvement solution" is used: Doherty amplifier + crest factor reduction (Crest Factor Reduction, CFR) + digital pre-distortion (Digital Pre-Distortion, DPD), which improves overall efficiency from about 10% to about 40% or even higher. Alternatively, a gallium nitride (GaN) power amplifier with higher efficiency is used to replace a lateral double-diffused MOSFET (Lateral Double-diffused MOSFET, LDMOS) power amplifier. However, related technologies for improving efficiency of the power amplifier are complex, costly, and technically difficult.

Another feasible technical solution is to reduce power consumption of the base station by performing inter-frequency handover for users when a plurality of power amplifiers carry a plurality of carriers. For example, a current quantity of users on each carrier in each sector of the base station is counted to obtain total usage in each sector, and whether to turn on or off the power amplifiers is determined according to a preset policy. Before the power amplifiers are turned off, these users are handed over to other power amplifiers that remain turned on in a manner such as inter-frequency handover. In this technical solution, before the power amplifiers are turned off, the users need to be handed over to other power amplifiers that remain turned on in a manner such as inter-frequency handover. This requires performing handover for the users served by the power amplifiers to be turned off, which is complex.

To resolve a problem of a waste of energy consumption of a base station, embodiments of this application provide still another solution. In embodiments of this application, a transmit power of the base station may be flexibly controlled based on a quantity of users. When the quantity of users is large, the base station works at full power. When the quantity of users is small, some power amplifiers are turned off to achieve energy saving. That is, from a perspective of a feed network of a base station antenna, embodiments of this application provide a new energy-saving feed network to reduce energy consumption of the base station antenna, so that a transmit power of the base station antenna can be dynamically adjusted based on the quantity of users on a premise that coverage of an antenna beam remains unchanged, thereby reducing energy consumption of the base station. This has definite advantages of a good energy-saving effect, a simple structure, low costs, and flexible configuration.

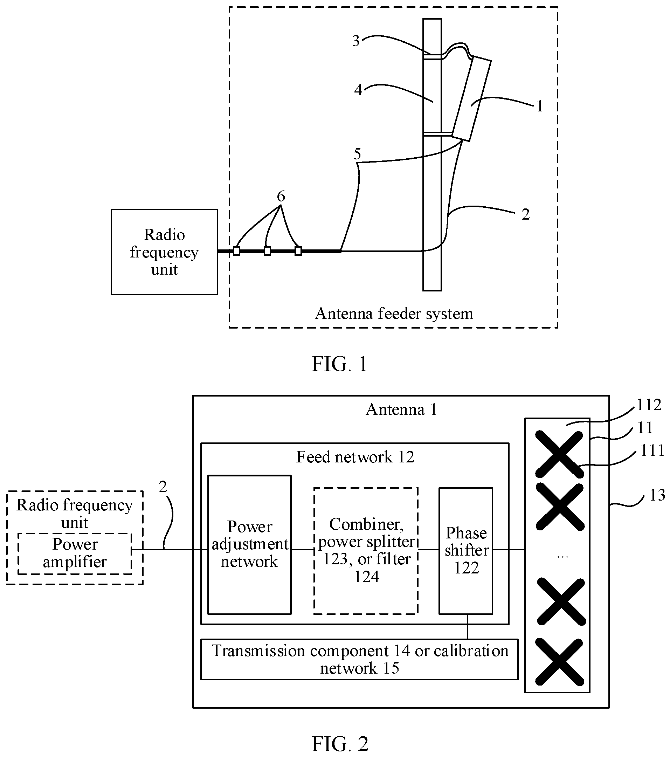

FIG. 1 is a diagram of composition of a base station system. As shown in FIG. 1, the base station system mainly includes an antenna feeder system and a radio frequency unit. As shown in FIG. 1, the antenna feeder system mainly includes a base station antenna 1, a feeder 2, an antenna adjustment support 3, a pole 4, a connector sealing piece 5, and a grounding apparatus 6. The radio frequency unit (Remote Radio Unit, RRU) is configured to convert a digital signal into a radio frequency signal, and transmit the radio frequency signal to space by using the antenna feeder system, thereby implementing wireless communication. The combination of the radio frequency unit and the antenna feeder system is also referred to as an active antenna unit (Active Antenna Unit, AAU), which can independently send, receive, and process a signal.

For example, in an actual working process, a main working process of the radio frequency unit includes: digital signal processing, radio frequency signal generation, and radio frequency signal transmission. Digital signal processing includes steps such as signal demodulation, encoding, and decoding. Radio frequency signal generation means that the radio frequency unit converts a digital signal into a radio frequency signal, that is, converts the digital signal into an analog signal, and performs modulation and amplification on the analog signal to obtain the radio frequency signal. Radio frequency signal transmission means that the radio frequency unit transmits a radio frequency signal to the feeder 2 of the antenna feeder system, and sends the radio frequency signal to space by using the base station antenna 1.

The base station system provided in embodiments of this application may be applicable to various communication systems, for example, a 5th generation (5th Generation, 5G) communication system or a new radio (new radio, NR) system, a 6G communication system, a long term evolution (long term evolution, LTE for short) system, a global system for mobile communications (global system for mobile communications, GSM for short), a code division multiple access (code division multiple access, CDMA for short) system, a wideband code division multiple access (wideband code division multiple access, WCDMA for short) system, a general packet radio service (general packet radio service, GPRS for short) system, an LTE frequency division duplex (frequency division duplex, FDD for short) system, an LTE time division duplex (time division duplexing, TDD for short) system, a universal mobile telecommunications system (universal mobile telecommunications system, UMTS for short), a worldwide interoperability for microwave access (worldwide interoperability for microwave access, WiMAX for short) communication system, and the like. Certainly, the base station system may be another communication system of an unlicensed frequency band. This is not limited.

FIG. 2 is a diagram of composition of a base station antenna. As shown in FIG. 2, the base station antenna 1 mainly includes an antenna array 11, a feed network 12, and a radome 13. The radiating element 11 and the feed network 12 are generally disposed in the radome 13. The radio frequency unit sends a radio frequency signal to the feeder 2. After being processed by the feed network 12, the signal of the feeder 2 is input into the antenna array 11. The antenna array 11 transmits the radio frequency signal to space, to form a wireless communication signal.

As shown in FIG. 2, the antenna array 11 is at least one independent array formed by a radiating element 111 and a metal reflection panel 112, where frequencies of radiating elements 111 may be the same or different, and the radiating element 111 is generally placed above the metal reflection panel 102. A plurality of phase shifters 122 correspond to the radiating elements 111, and each phase shifter 122 is configured to adjust a phase of a signal in the corresponding radiating element 111, so as to generate a phase difference with a radio frequency signal of another radiating element 111, thereby forming different radiation beam directions.

Optionally, the phase shifter 122 of the feed network 12 may implement different radiation beam directions by using a transmission component 14, and the transmission component 14 is a system used for phase control. The transmission component 14 is a pull rod configured to control the phase shifter 122. When the transmission component 14 is shifted to different positions, the phase shifter 122 outputs different phase states. Each phase state corresponds to one beam direction. Alternatively, the phase shifter 122 of the feed network 12 may be connected to a calibration network 15 to obtain a calibration signal required by the system and perform phase adjustment. In addition to a phase-shifting network, the feed network 102 may further include modules such as a power splitter 123 and a filter 124 for performance extension. The power splitter 123, also referred to as a power divider (power divider), is a component that splits one source of input signal energy into two or more outputs of equal or unequal energy. Conversely, the power splitter 123 may also combine a plurality of sources of signal energy into one output, and in this case, the power splitter 123 may also be referred to as a combiner.

In embodiments of this application, as shown in FIG. 2, a power amplifier of the radio frequency unit sends the radio frequency signal to the feeder 2. The feeder 2 sends the signal to the feed network 12. After the radio frequency signal enters the feed network 12, power allocation is first performed by using a power adjustment network. A signal obtained after the power allocation is sent to the phase shifter 122 corresponding to each radiating element 111 in the antenna array 11. Each radiating element 111 sends a phase-shifted signal to space, to form a wireless communication signal.

In embodiments of this application, a radio frequency power amplifier (radio frequency power amplifier, RFPA) is a main part in a transmit system, and is definitely very important. In a pre-stage circuit of a transmitter, a radio frequency signal generated by a modulation oscillation circuit has a very small power, and needs to be amplified through a series of stages (a buffer stage, an intermediate amplification stage, and a final power amplification stage) to obtain a sufficient radio frequency power before being fed to an antenna for radiation. To obtain a sufficiently large radio frequency output power, the radio frequency power amplifier needs to be used. After a modulator generates a radio frequency signal, the RFPA amplifies the radio frequency signal to a sufficient power, and then the radio frequency signal is transmitted by the antenna array 11 after passing through the feed network 12.

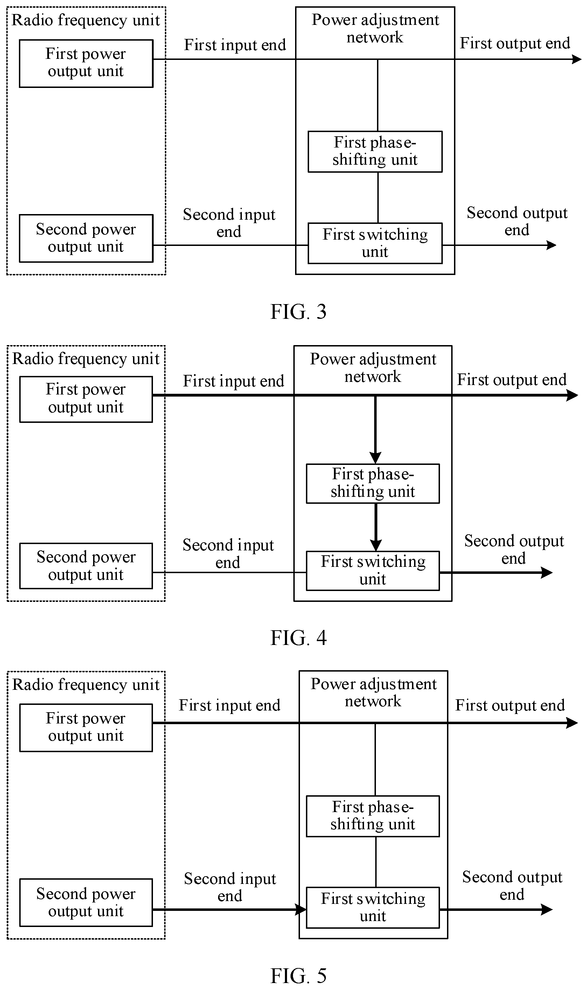

FIG. 3 is a diagram of composition of a power adjustment network. As shown in FIG. 3, the power adjustment network includes a first input end, a first output end, a second input end, a second output end, a first phase-shifting unit, and a first switching unit. The first input end of the power adjustment network is separately connected to the first output end of the power adjustment network and an input end of the first phase-shifting unit, and the first input end is configured to connect to a first power output unit. One input end of the first switching unit is connected to an output end of the first phase-shifting unit, another input end of the first switching unit serves as the second input end of the power adjustment network, an output end of the first switching unit serves as the second output end of the power adjustment network, and the second input end is configured to connect to a second power output unit. The first output end and the second output end are respectively configured to provide input signals of antenna arrays.

FIG. 4 is a diagram of a first working state of a power adjustment network. As shown in FIG. 4, when the power adjustment network is in the first working state, the first switching unit connects the first phase-shifting unit and the second output end of the power adjustment network. In the first working state, a radio frequency signal of the first power output unit is transmitted to the first input end of the power adjustment network, is output through the first output end, and after being phase-shifted by the first phase-shifting unit, is output from the second output end after passing through the first switching unit. That is, the radio frequency signal of the first power output unit is input into the first input end of the power adjustment network, and is output through the first output end and the second output end.

Optionally, after being output from the first output end and the second output end, the radio frequency signal is input into the phase shifter 122 corresponding to each radiating element 111 after passing through the power divider or the filter, and is output to space by using each radiating element 111.

FIG. 5 is a diagram of a second working state of a power adjustment network. As shown in FIG. 5, when the power adjustment network is in the second working state, the first switching unit connects the second input end of the power adjustment network and the second output end of the power adjustment network. In the second working state, a radio frequency signal of the first power output unit is transmitted to the first input end of the power adjustment network, and is output through the first output end, while a radio frequency signal of the second power output unit is transmitted to the second input end of the power adjustment network, and is output through the second output end. That is, the radio frequency signals output by the first power output unit and the first power output unit are respectively input into the first input end and the second input end of the power adjustment network, and are respectively output through the first output end and the second output end.

Optionally, after being output from the first output end and the second output end, the radio frequency signals are separately input into the phase shifter 122 corresponding to each radiating element 111 after passing through the power divider or the filter, and are output to space by using each radiating element 111.

With reference to FIG. 4 and FIG. 5, the first working state and the second working state of the power adjustment network are further analyzed. It is assumed that an output power of the first power output unit is P1, and an output power of the second power output unit is P2. When the power adjustment network is in the first working state, the antenna array 11 transmits a radio frequency signal at the power P1; and when the power adjustment network is in the second working state, the antenna array 11 transmits a radio frequency signal at a power (P1+P2).

In embodiments of this application, a plurality of thresholds may be set for a quantity of users, to determine a relationship between the quantity of users and the threshold, and determine a switching state of the first switching unit. For example, when the quantity of users is less than a first threshold, the first switching unit is controlled to perform connection switching, so that the first switching unit connects the first phase-shifting unit and the second output end. In this way, the power adjustment network is in the first working state, and the antenna array 11 transmits the radio frequency signal at the power P1, thereby reducing a transmit power of the antenna array 11. When the quantity of users is greater than or equal to the first threshold, the first switching unit is controlled to perform connection switching, so that the first switching unit connects the second input end and the second output end. In this way, the power adjustment network is in the second working state, and the antenna array 11 transmits the radio frequency signal at the power (P1+P2), thereby increasing the transmit power of the antenna array 11. The first switching unit may perform connection switching based on the quantity of users. A specific implementation of the first switching unit is not described in embodiments of this application.

Optionally, the output power of the first power output unit is equal to the output power of the second power output unit, that is, P1=P2. The first working state of the power adjustment network is also referred to as a half-power state, and the second working state of the power adjustment network is also referred to as a full-power state.

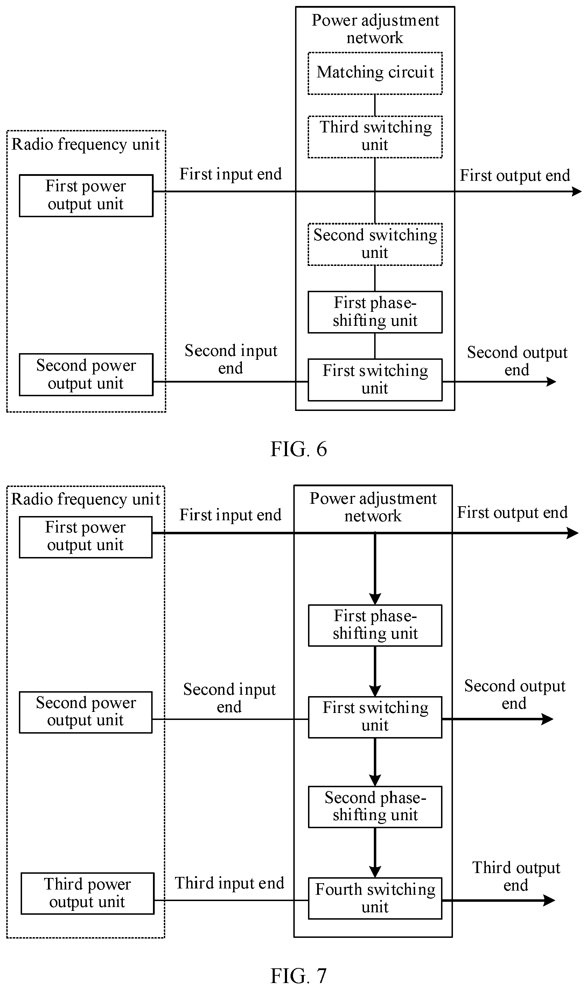

FIG. 6 is a diagram of composition of another power adjustment network. As shown in FIG. 6, optionally, the power adjustment network further includes a second switching unit. One end of the second switching unit is connected to the first input end, and the other end is connected to the first phase-shifting unit. The second switching unit is configured to control connection and disconnection between the first input end and the second output end. When the second switching unit is connected, the first switching unit may connect the first input end and the second output end, so that the power adjustment network is in the first working state; or the first switching unit may connect the second input end and the second output end, so that the power adjustment network is in the second working state. When the second switching unit is disconnected, the first switching unit may connect the second input end and the second output end, so that the power adjustment network is in the second working state. When the second switching unit is connected, the power adjustment network may implement switching between the first working state and the second working state by using the first switching unit. When the second switching unit is disconnected, the power adjustment network may implement the second working state by using the first switching unit, but cannot switch to the first working state.

As shown in FIG. 6, optionally, the power adjustment network further includes a matching circuit, to implement circuit matching of the first switching unit in different states. The matching circuit may be an L-shaped matching network formed by one inductor and one capacitor connected in series or in parallel; or a π-shaped matching network formed by one inductor and two capacitors; or a T-shaped matching network formed by one capacitor and two inductors; or a matched stub matching network implemented by introducing a fixed-length open-circuit or short-circuit line segment on a transmission line. Optionally, the matching circuit is connected to the first input end.

Optionally, the power adjustment network further includes a third switching unit. For example, the third switching unit is connected between the first input end and the matching circuit, and is configured to implement connection and disconnection of the matching circuit.

FIG. 7 is a diagram of composition of still another power adjustment network. Optionally, as shown in FIG. 7, the radio frequency unit may further include a third power output unit. It is assumed that an output power of the third power output unit is P3. By disposing a second phase-shifting unit and a fourth switching unit that are disposed in a same manner as the first phase-shifting unit and the first switching unit, the power adjustment network may be in more working states, so that the antenna array 11 can transmit radio frequency signals at powers P1, (P1+P2), (P1+P3), and (P1+P2+P3), thereby increasing a transmit power selection range of the antenna array 11. It can be learned by analogy that a plurality of power output units may be disposed, so that an output power selection range of the antenna array is larger.

That is, embodiments of this application provide a dynamically adjustable power adjustment network. The network may distribute one or more input radio frequency powers to a feed network of an antenna subarray. When there is only one input power, the input power is evenly distributed to an input port of the feed network of the antenna subarray. When there are a plurality of inputs, the plurality of powers may also be evenly distributed to the input port of the feed network of the antenna subarray.

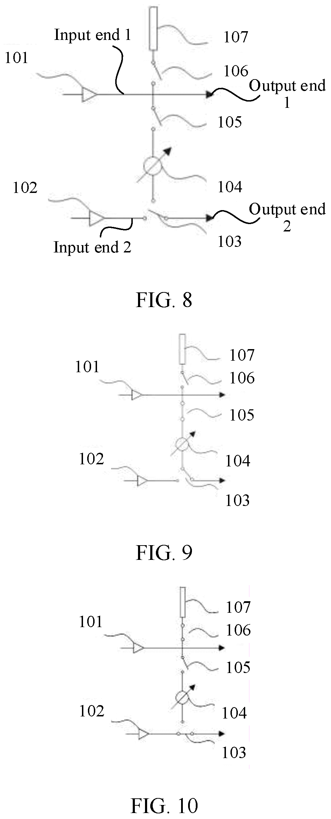

FIG. 8 to FIG. 10 show embodiments of a power adjustment network. In embodiments of this application, composition and a working state of the power adjustment network are described as examples according to FIG. 8 to FIG. 12. In embodiments of this application, the power adjustment network is not limited in its implementation form, and may be implemented by using a microstrip, a coaxial cable, a modular component, or the like.

In embodiments, the first switching unit may be implemented by a single-pole double-throw switch. For example, a first input end of the single-pole double-throw switch is connected to the output end of the first phase-shifting unit, the first input end is connected to the second input end, and an output end is connected to the second output end. When the single-pole double-throw switch is connected to the first input end, the second output end is connected to the first phase-shifting unit, and the power adjustment network is in the first working state. When the single-pole double-throw switch is connected to the first input end, the second output end is connected to the second input end, and the power adjustment network is in the second working state. Therefore, the single-pole double-throw switch implements switching of the power adjustment network between the first working state and the second working state.

In embodiments, an implementation of the first phase-shifting unit is a phase shifter, so that a phase requirement is met when the radio frequency signal is output from the second output end. The third switching unit and the fourth switching unit are single-pole single-throw switches. The first power output unit and the second power output unit are power amplifiers. A specific model and a type of the power amplifier are not limited in embodiments of this application.

As shown in FIG. 8, in embodiments, the radio frequency unit includes a first power amplifier 101 and a second power amplifier 102, and the power adjustment network includes a single-pole double-throw switch 103, a phase shifter 104, a single-pole single-throw switch 105, a single-pole single-throw switch 106, a matching circuit 107, an input end 1, an input end 2, an output end 1, and an output end 2. The input end 1 is connected to the output end 1 to form a first branch. The input end 1 is connected to the single-pole single-throw switch 105, the single-pole single-throw switch 105 is connected to the phase shifter 104, the phase shifter 104 is connected to one input end of the single-pole double-throw switch 103, and an output end of the single-pole double-throw switch 103 is connected to the output end 2 to form a second branch. The input end 2 is connected to one input end of the single-pole double-throw switch 103, and the output end of the single-pole double-throw switch 103 is connected to the output end 2 to form a third branch. The first power amplifier 101 is connected to the input end 1, and the second power amplifier 102 is connected to the input end 2.

Optionally, in embodiments, the power adjustment network includes the single-pole double-throw switch 106 and the matching circuit 107. The single-pole double-throw switch 106 is disposed between the matching circuit 107 and the input end 1, and the matching circuit 107 is configured to perform circuit matching.

In embodiments of this application, the first power amplifier 101 and the second power amplifier 102, as radio frequency signal amplifiers, are main sources of power consumption of the base station antenna. The single-pole double-throw switch 103 is configured to switch to an output end of the second power amplifier 102 or an output end of the phase shifter 104. The phase shifter 104 is configured to provide a phase difference required for beam scanning of the antenna array. The single-pole single-throw switch 105 and the single-pole single-throw switch 106 are configured to implement connection or disconnection of a radio frequency circuit. The matching circuit 107 is configured to implement circuit matching in different switch states.

As shown in FIG. 9, in embodiments, when the single-pole double-throw switch 103 switches to a state shown in FIG. 9, the first power amplifier 101 is turned on, the second power amplifier 102 is turned off, and the single-pole single-throw switch 106 is turned off. In this case, the power adjustment network may be understood as a one-to-two power divider, and an output power of the first power amplifier 101 is divided into two outputs. This state may be understood as an energy-saving state, and is applicable to a case with a small quantity of users.

As shown in FIG. 10, in embodiments, when the single-pole double-throw switch 103 switches to a state shown in FIG. 10, both the first power amplifier 101 and the second power amplifier 102 are in a working state, and the single-pole single-throw switch 106 is closed, to ensure circuit matching. An output power of the first power amplifier 101 is output from the output end 1 through the first branch, and an output power of the second power amplifier 102 is output from the output end 2 through the third branch. This state is a full-power state, and is applicable to a case with a large quantity of users.

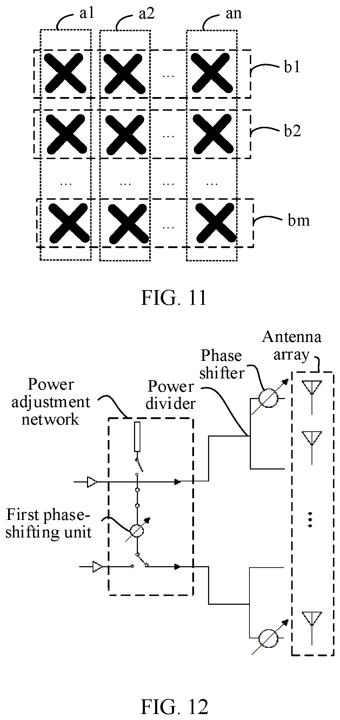

FIG. 11 to FIG. 14 show embodiments of a base station antenna. In embodiments, a working principle of the power adjustment network is described as an example by applying the power adjustment network to an antenna system.

In embodiments of this application, a direction is defined as follows: "Forward" refers to a normal direction of an antenna aperture, which is a main radiation direction of the antenna; "longitudinal" refers to a length direction of an antenna array in each column, which is basically perpendicular to the ground; and "lateral" refers to a horizontal direction along the antenna aperture.

As shown in FIG. 11, embodiments of this application provide a two-dimensional antenna array. Generally, an antenna array appears in a form of two dimensions, and beamforming in different directions is implemented by using a phase difference between radiating elements in the two dimensions. For example, as shown in FIG. 11, it is assumed that the antenna array appears in a form of a matrix, where a first dimension is a row, for example, an antenna array b1 in a first row, an antenna array b2 in a second row, ..., and an antenna array bn in an n^{th} row shown in FIG. 11, and a second dimension is a column, for example, an antenna array a1 in a first row, an antenna array a2 in a second row, ..., and an antenna array an in an n^{th} row shown in FIG. 11.

As shown in FIG. 11, it is assumed that an antenna array in each row is disposed parallel to a horizontal plane. In a dimension of a row, a phase difference between radiating elements in different rows is controlled by using the phase shifter, so that beamforming in this dimension can be implemented in a vertical dimension. In a dimension of a column, an antenna array in each column is disposed perpendicular to a horizontal plane. It is assumed that a phase difference between radiating elements in different columns is controlled by using the phase shifter, so that beamforming in this dimension can be implemented in a horizontal dimension.

As shown in FIG. 12, an antenna matrix in a row or a column is used as an example for description. The output end 1 and the output end 2 of the power adjustment network are respectively connected to a power divider, a phase shifter, and an antenna array. The power divider is configured to distribute a power and input the power to a plurality of radiating elements of the antenna array. The phase shifter is configured to implement a phase difference between different radiating elements. For example, an antenna matrix in a column includes eight radiating elements, and the eight radiating elements may be divided into two groups. A first group of radiating elements is connected to the output end 1 and the corresponding power divider and phase shifter, and a second group of radiating elements is connected to the output end 2 and the corresponding power divider and phase shifter. It should be noted that the first phase-shifting unit is configured to control a phase difference between the two groups of radiating elements, so that a phase of the second output end of the power adjustment network does not change before and after switching between the first working state and the second working state; and the phase shifter is configured to control a phase difference between radiating elements in each group.

As shown in FIG. 12, the first power amplifier 101 feeds a power of the first power amplifier 101 into the two groups of radiating elements of the antenna matrix through the first branch and the second branch.

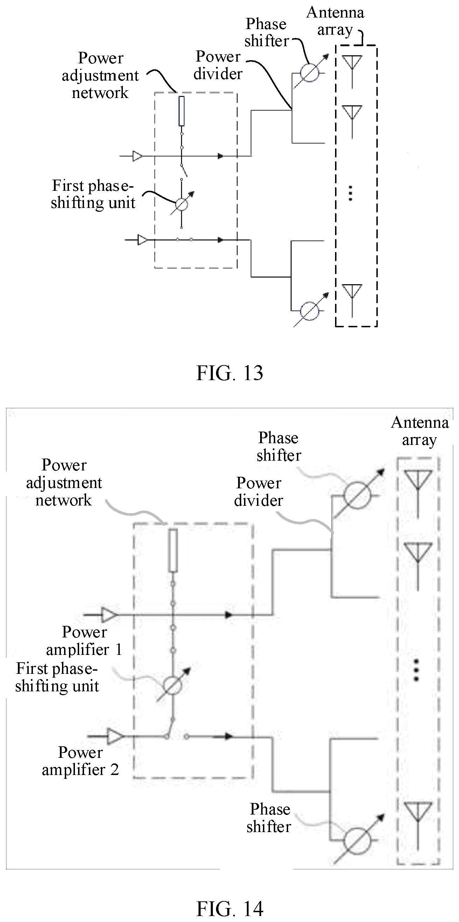

As shown in FIG. 13, the first power amplifier 101 feeds a power of the first power amplifier 101 into the first group of radiating elements of the antenna matrix through the first branch. The first power amplifier 102 feeds a power of the second power amplifier 102 into the second group of radiating elements of the antenna matrix through the third branch.

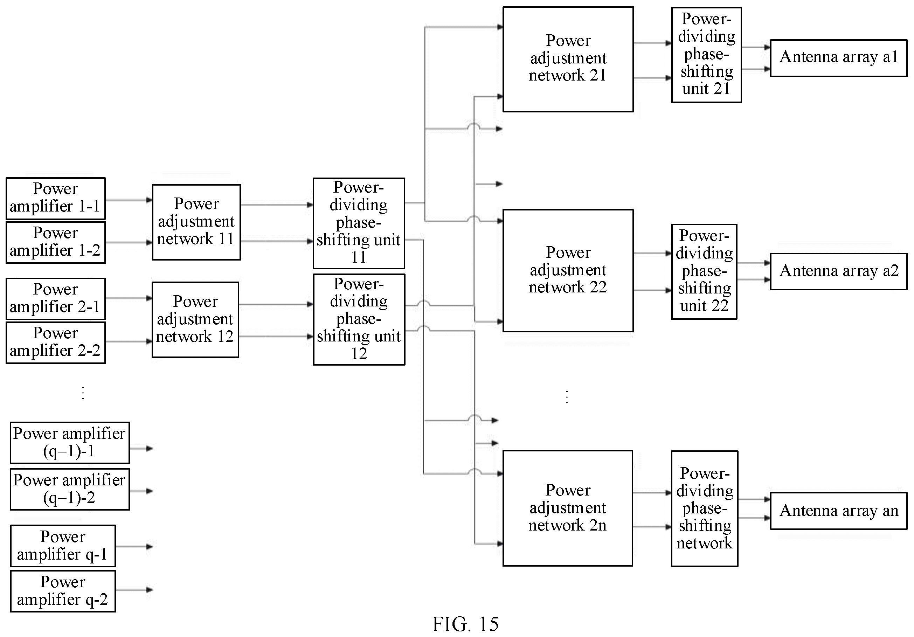

As shown in FIG. 14, the power adjustment network may further have a third working state. In the third working state, when the single-pole double-throw switch 103 switches to a state shown in FIG. 14, both the first power amplifier 101 and the second power amplifier 102 are in a working state, and the single-pole single-throw switch 106 is closed, to ensure circuit matching. The input end 2, the single-pole double-throw switch 103, the phase shifter 104, and the output end 1 form a fourth branch. Output of the first power amplifier 101 is delivered to the output end 1 through the first branch, and output of the second power amplifier 102 is delivered to the output end 1 through the fourth branch. The state is a full-power state of a first antenna array, and is applicable to a case with a large quantity of users within a beam range of the first antenna array. As shown in FIG. 15, power adjustment in two dimensions may be implemented by using a plurality of power adjustment networks, so as to achieve a better energy-saving effect. The power divider and the phase shifter between the power adjustment network and the antenna array are referred to as a power-dividing phase-shifting unit for short, so as to simplify the diagram.

As shown in FIG. 15, based on the antenna array shown in FIG. 11, for example, for an antenna array in n columns and m rows, the power adjustment network shown in FIG. 12, FIG. 13, or FIG. 14 is used in each column, and a phase difference between a plurality of radiating elements in each column may be adjusted by using the power-dividing phase-shifting unit, so that a phase difference exists in an antenna array in each row, thereby implementing beams in different vertical directions.

For example, a power adjustment network 21 and a power-dividing phase-shifting unit 21 shown in FIG. 15 are connected to an antenna array a1. The power-dividing phase-shifting unit 21 may adjust a phase difference between a plurality of radiating elements in the antenna array a1, so as to implement beams in different vertical directions. The power adjustment network 21 may adjust an input power of the antenna array a1. As shown in FIG. 15, a power adjustment network 22 and a power-dividing phase-shifting unit 22 are connected to an antenna array a2. The power power-dividing phase-shifting unit 22 may adjust a phase difference between a plurality of radiating elements in the antenna array a2, so as to implement beams in different vertical directions. The power adjustment network 22 may adjust an input power of the antenna array a2. By analogy, as shown in FIG. 15, a power adjustment network 2n and a power-dividing phase-shifting unit 2n are connected to an antenna array an. The power-dividing phase-shifting unit 2n may adjust a phase difference between a plurality of radiating elements in the antenna array an, so as to implement beams in different vertical directions. The power adjustment network 2n may adjust an input power of the antenna array an. For example, for the antenna array in n columns and m rows, two power adjustment networks shown in FIG. 12, FIG. 13, or FIG. 14 are used. After a first power adjustment network is connected to a power-dividing phase-shifting unit, n signals of different phases are output, and are input into a first input end of the power adjustment network in an adjustment column, so that different columns have phase differences, thereby implementing beamforming in different horizontal directions. After a second power adjustment network is connected to a power-dividing phase-shifting unit, n signals of different phases are output, and are input into a second input end of the power adjustment network in an adjustment column, so that different columns have phase differences, thereby implementing beamforming in different horizontal directions.

For example, as shown in FIG. 15, after being connected to a power-dividing phase-shifting unit 11, a power amplifier 1-1, a power amplifier 1-2, and a power adjustment network 11 are respectively connected to first input ends of power adjustment networks in n adjustment columns. That is, the power-dividing phase-shifting unit 11 outputs n signals of different phase differences, and respectively inputs the n signals to first input ends of the power adjustment network 21, the power adjustment network 22, ..., and the power adjustment network 2n, so as to adjust a phase difference between different columns of the antenna array, thereby implementing beamforming in different horizontal directions. For example, as shown in FIG. 15, after being connected to a power-dividing phase-shifting unit 12, a power amplifier 2-1, a power amplifier 2-2, and a power adjustment network 12 are respectively connected to second input ends of power adjustment networks in n adjustment columns. That is, the power-dividing phase-shifting unit outputs n signals of different phase differences, and inputs the n signals to second input ends of the power adjustment network 21, the power adjustment network 22, ..., and the power adjustment network 2n, so as to adjust a phase difference between different columns of the antenna array, thereby implementing beamforming in different horizontal directions.

Further, working states of the power amplifier 1-1, the power amplifier 1-2, the power amplifier 2-1, and the power amplifier 2-2 are analyzed to describe implementations of different input powers of the antenna array.

When all of the four power amplifiers are turned on, the base station is in a full-power state.

When three of the power amplifiers are turned on, the base station is in a 3/4-power state. For example, when the power amplifier 1-2 is turned off, the power adjustment network 11 is in an energy-saving state (the first working state); or when the power amplifier 2-2 is turned off, the power adjustment network 12 is in an energy-saving state. The power adjustment network 21, the power adjustment network 22, ..., and the power adjustment network 2n are in a non-energy-saving state (the second working state).

When two of the power amplifiers are turned on, the base station is in a half-power state. For example, when the power amplifier 1-2 and the power amplifier 2-2 are turned off, and the power amplifier 1-1 and the power amplifier 2-1 are turned on, both the power adjustment network 11 and the power adjustment network 12 are in an energy-saving state, and the power adjustment network 21, the power adjustment network 22, ..., and the power adjustment network 2n are in a non-energy-saving state. Alternatively, when the power amplifier 2-1 and the power amplifier 2-2 are turned off, and the power amplifier 1-1 and the power amplifier 1-2 are turned on, the power adjustment network 11 is in a non-energy-saving state, and the power adjustment network 21, the power adjustment network 22, ..., and the power adjustment network 2n are in an energy-saving state.

When one of the power amplifiers is turned on, the base station is in a 1/4-power state. For example, when the power amplifier 1-2, the power amplifier 2-1, and the power amplifier 2-2 are turned off, and the power amplifier 1-1 is turned on, the power adjustment network 11 is in an energy-saving state, and the power adjustment network 21, the power adjustment network 22, ..., and the power adjustment network 2n are in an energy-saving state.

That is, after the power adjustment network is added, the power amplifier and the working state of the power adjustment network may be flexibly configured based on the current quantity of users, so as to adjust power consumption of the base station, thereby ensuring communication quality of users while achieving energy saving.

For example, each column of antenna may be divided into q parts, to obtain q different areas, where q is an integer greater than or equal to 1, so that input powers of the q different areas in the antenna array can be different from each other, thereby facilitating flexible management of the antenna array. That is, an input power of a corresponding antenna array may be adjusted based on the quantity of users within q different beam ranges, which can achieve an energy-saving effect while ensuring communication quality of users.

It should be noted that a division method is not limited in embodiments of this application. A quantity of parts into which each column of antenna is divided may be the same or different, and a quantity of radiating elements in each part may be the same or different. For example, when the quantity of parts into which each column of antenna is divided is the same, and the quantity of radiating elements in each part is the same, the antenna array in m rows and n columns is equally divided into a plurality of same areas.

In a possible implementation, a feed network of the antenna array a1 shown in FIG. 15 is connected to a first part of antenna array of the antenna array a1, a feed network of the antenna array a2 shown in FIG. 15 is connected to a first part of antenna array of the antenna array a2, and by analogy, a feed network of the antenna array an shown in FIG. 15 is connected to a first part of antenna array of the antenna array an. That is, the network shown in FIG. 15 may be used for an antenna array in a first area of the q areas. By analogy, based on a same working principle shown in FIG. 15, antenna arrays in other areas of the q areas are connected by using a network that is the same as or similar to that shown in FIG. 15.

In embodiments of this application, the power adjustment network is added between the power amplifier and a feed network of a base station antenna, so that power of the base station is reduced at low costs when there are a small quantity of users. That is, by controlling the connection state of the single-pole double-throw switch 103 of the power adjustment network, the output power of one or two power amplifiers may be distributed to the antenna array, thereby implementing switching between the energy-saving state and the non-energy-saving state. It should be noted that, in the energy-saving state and the non-energy-saving state, the antenna array always works at full capacity, with all radiating elements being in a working state. Therefore, coverage of an antenna beam remains consistent throughout.

That is, the power adjustment network may be placed in a horizontal beam scanning network of the base station antenna, or may be placed in a vertical beam scanning network. When all of the power amplifiers are turned on, the base station is in a full power state. When three of the four power amplifiers are turned on, the base station is in a 3/4-power state. When two of the four power amplifiers are turned on, the base station is in a half-power state. When one of the four power amplifiers is turned on, the base station is in a 1/4-power state. Therefore, after the power adjustment network is added, the power amplifier and the working state of the power adjustment network may be flexibly configured based on the current quantity of users, so as to adjust power consumption of the base station, thereby ensuring communication quality of users while achieving energy saving.

In embodiments of this application, when a quantity of users in an area covered by the base station antenna is large, all of the power amplifiers of the base station are configured to be turned on in a full-power state, so as to ensure a communication capacity. When there are a small quantity of users, some of the power amplifiers of the base station are configured to be turned off, and the power adjustment network evenly distributes the power to the antenna arrays, so that the coverage remains unchanged but the transmit power is reduced, thereby effectively reducing power consumption.

In embodiments of this application, the switching unit or the switch may be a metal-oxide-semiconductor field-effect transistor MOSFET, a diode, a micro-electro-mechanical system MEMS, or a reed switch. The matching circuit may be a microstrip circuit or a lumped-element circuit integrating an inductor, a capacitor, and the like. The phase shifter may be an analog phase shifter.

In embodiments of this application, working states of the power amplifier and the power adjustment network may be flexibly configured based on the quantity of users. That is, the transmit power of the base station antenna may be flexibly configured based on the quantity of users. When there are a small quantity of users, some power amplifiers are turned off to reduce power consumption. After power adjustment networks are disposed in a horizontal power adjustment network and a vertical power adjustment network respectively, full power, half power, and quarter power outputs can be implemented, thereby implementing flexible configuration of the output power. In the energy-saving and non-energy-saving states before and after the power adjustment network is adjusted, the coverage of the base station antenna remains unchanged, thereby ensuring communication quality of users while achieving energy saving. The power adjustment network features a simple structure, low costs, easy implementation, and a significant energy-saving effect.

An embodiment of this application provides a feed network, including the foregoing power adjustment network, so that a transmit power of a base station antenna can be dynamically adjusted based on a quantity of users without changing an original beam scanning range of the base station antenna, thereby achieving energy saving. That is, in the feed network in this embodiment of this application, basic components such as a single-pole single-throw switch, a single-pole double-throw switch, a power divider, and a phase shifter are used to form a dynamically adjustable power distribution network, a working state of a power amplifier is dynamically adjusted based on the quantity of users, and an output power of one or more power amplifiers is distributed to an antenna array. In this way, the output power dynamically changes with the quantity of users, that is, the transmit power is low when the quantity of users is small, and the transmit power is high when the quantity of users is large, thereby reducing energy consumption of a base station.

A person of ordinary skill in the art may be further aware that, units and algorithm steps of the examples described in combination with embodiments disclosed in this specification can be implemented by electronic hardware, computer software, or a combination thereof. To clearly describe interchangeability between the hardware and the software, compositions and steps of each example have been generally described in the foregoing descriptions based on functions. Whether these functions are performed in a hardware manner or a software manner depends on a particular application and a design constraint condition of the technical solutions. A person of ordinary skill in the art may use different methods to implement the described functions for each particular application, but it should not be considered that the implementation goes beyond the scope of this application.

The steps of the methods or algorithms described in embodiments disclosed in this specification may be implemented by hardware and a software module executed by the processor or a combination of hardware and a software module executed by the processor. The software module may be configured in a random access memory (RAM), a memory, a read-only memory (ROM), an electrically programmable ROM, an electrically erasable programmable ROM, a register, a hard disk, a removable disk, a CD-ROM, or a storage medium in any other forms well-known in the art.

In the foregoing specific implementations, the objective, technical solutions, and beneficial effects of this application are further described in detail. It should be understood that the foregoing descriptions are merely specific implementations of this application, but are not intended to limit the protection scope of this application. Any modification, equivalent replacement, or improvement made without departing from the spirit and principle of this application should fall within the protection scope of this application.

## Claims

1. A power adjustment network, comprising:
a first input end, configured to electrically connect to a first power amplifier;
a second input end, configured to electrically connect to a second power amplifier;
a first output end, configured to electrically connect to a first antenna array;
a second output end, configured to electrically connect to a second antenna array;
a first phase-shifting unit, wherein an input end is electrically connected to the first input end, and is configured to control a phase of a radio frequency signal that is output when the first input end and the second output end are connected; and
a first switching unit, wherein one input end is connected to an output end of the first phase-shifting unit, another input end is electrically connected to the second input end, and an output end is electrically connected to the second output end, wherein
a first branch is formed by connecting the first input end and the first output end; a second branch is formed by connecting the first input end, the first phase-shifting unit, the first switching unit, and the second output end; and a third branch is formed by connecting the second input end, the first switching unit, and the second output end; and
the first switching unit is configured to: control the second branch to be connected, so that the first power amplifier provides a radio frequency signal of a first power for the first antenna array and the second antenna array; or control the third branch to be connected, so that the first power amplifier provides a radio frequency signal of a first power for the first antenna array, and the second power amplifier provides a radio frequency signal of a second power for the second antenna array.

2. The power adjustment network according to claim 1, wherein a fourth branch is formed by connecting the second input end, the first switching unit, the first phase-shifting unit, and the first output end, and the first switching unit is further configured to control the fourth branch to be connected, so that the first power amplifier and the second power amplifier provide a radio frequency signal of a third power for the first antenna array, wherein the third power is a sum of the first power and the second power.

3. The power adjustment network according to claim 1 or 2, wherein a second switching unit is disposed on the second branch, and the second switching unit is configured to connect or disconnect the second branch.

4. The power adjustment network according to any one of claims 1 to 3, further comprising: a matching circuit, connected to the first input end, and configured to perform circuit matching for the first branch when the first switching unit controls the third branch to be connected.

5. The power adjustment network according to claim 4, wherein a third switching unit is further disposed between the matching circuit and the first input end, and the third switching unit is configured to connect or disconnect the matching circuit and the first input end.

6. The power adjustment network according to claim 4 or 5, wherein the matching circuit comprises a microstrip circuit or a lumped-element circuit, and the lumped-element circuit comprises an inductor or a capacitor.

7. The power adjustment network according to any one of claims 1 to 6, wherein the first phase-shifting unit comprises a phase shifter, and/or the first switching unit comprises a single-pole double-throw switch.

8. The power adjustment network according to claim 7, wherein the phase shifter is an analog phase shifter; or the single-pole double-throw switch is a metal-oxide-semiconductor field-effect transistor, a diode, a micro-electro-mechanical system, or a reed switch.

9. The power adjustment network according to any one of claims 1 to 8, further comprising a third input end, a third output end, a second phase-shifting unit, and a fourth switching unit, wherein
an input end of the second phase-shifting unit is connected to the first switching unit, an output end of the second phase-shifting unit is connected to one input end of the fourth switching unit, and the second phase-shifting unit is configured to control a phase of a radio frequency signal that is output when the second input end and the third output end are connected; and
another input end of the fourth switching unit is connected to the third input end, and an output end of the fourth switching unit is connected to the third output end.

10. The power adjustment network according to any one of claims 1 to 9, further comprising a control module, configured to control the first switching unit to switch between connecting the second branch and connecting the third branch.

11. The power adjustment network according to claim 10, further comprising a detection module, configured to: detect a quantity of users within a beam range of the antenna array; and send a first signal to the control module when the quantity of users exceeds a user threshold, wherein the first signal indicates the first switching unit to connect the third branch, and send a second signal to the control module when the quantity of users does not exceed the user threshold, wherein the second signal indicates the first switching unit to connect the second branch.

12. A feed network, comprising: a first power divider, a second power divider, and the power adjustment network according to any one of claims 1 to 11, wherein an input end of the first power divider is connected to the first output end, and an output end of the first power divider is connected to the first antenna array; and an input end of the second power divider is connected to the second output end, and an output end of the second power divider is connected to the second antenna array.

13. The feed network according to claim 12, further comprising a third phase-shifting unit and a fourth phase-shifting unit, wherein the output end of the first power divider is connected to the third phase-shifting unit, the third phase-shifting unit is connected to the first antenna array, and the third phase-shifting unit is configured to adjust a phase difference between different radiating elements of the first antenna array; and the output end of the second power divider is connected to the fourth phase-shifting unit, the fourth phase-shifting unit is connected to the second antenna array, and the fourth phase-shifting unit is configured to adjust a phase difference between different radiating elements of the second antenna array.

14. The feed network according to claim 13, further comprising a transmission component or a calibration network, wherein the transmission component is configured to perform phase adjustment by controlling a pull-rod position of the first phase-shifting unit, the third phase-shifting unit, or the fourth phase-shifting unit, and the calibration network is configured to perform phase adjustment on the first phase-shifting unit, the third phase-shifting unit, or the fourth phase-shifting unit by comparing calibration signals.

15. A feed network, configured to control an input power of an antenna array in n rows and m columns, wherein both n and m are integers greater than or equal to 1, and the feed network comprises at least two power adjustment networks according to any one of claims 1 to 11, wherein a first power adjustment network is configured to adjust an input power between different rows in the n rows of the antenna array, or a second power adjustment network is configured to adjust an input power between different columns in the m columns of the antenna array.

16. The feed network according to claim 15, wherein the first power adjustment network is connected in series to the second power adjustment network, so that the two power adjustment networks simultaneously adjust the input power of the antenna array.

17. A base station antenna, comprising an antenna array and the feed network according to any one of claims 12 to 16, wherein the antenna array comprises a first antenna array and a second antenna array, and the feed network is configured to: perform feeding processing on signals received or sent by the first antenna array and the second antenna array, and adjust input powers of the first antenna array and the second antenna array.

18. A base station system, comprising: a radio frequency unit and the base station antenna according to claim 17, wherein the radio frequency unit comprises at least a first power amplifier and a second power amplifier, the first power amplifier is electrically connected to the first input end and is configured to provide a radio frequency signal of a first power, and the second power amplifier is electrically connected to the second input end and is configured to provide a radio frequency signal of a second power, wherein when the first switching unit controls the second branch to be connected, the second power amplifier is turned off, and when the first switching unit controls the third branch to be connected, the second power amplifier works.
